# DEMANDE DE BREVET EUROPEEN

(11) **EP 1 879 220 A2**
(43) Date de publication de la demande: **16.01.2008**
(21) Numéro de dépôt: 07112043.0
(22) Date de dépôt: 09.07.2007
(51) Int. Cl.: H01L 21/18

(54) **Procédé de collage hydrophobe direct de deux substrats utilisés en électronique, optique ou opto-électronique.**

(30) Priorité: 11.07.2006 FR 0606311
(71) Demandeur: S.O.I.Tec Silicon on Insulator Technologies, 38190 Bernin (FR)
(72) Inventeur: Mazure, Carlos, 38190, Bernin (FR); Bourdelle, Konstantin, 38920, Crolles (FR); Rayssac, Olivier, (FR)
(74) Mandataire: Bomer, Françoise Marie

(57) **Abrégé**

L'invention concerne un procédé de collage hydrophobe direct des faces avant (11, 21) de deux substrats (1, 2), destinés à être utilisés en l'électronique, en optique ou en opto-électronique, dont l'un au moins comprend une couche de matériau semi-conducteur (1, 13, 2, 20, 23) qui s'étend sur sa face avant (11, 21), ou à proximité de celle-ci.

Ce procédé est remarquable en ce qu'il comprend les étapes suivantes consistant à :
soumettre au moins la face avant (11, 21) du substrat comprenant un semi-conducteur ou au moins l'une des faces avant (11,21) des deux substrats si les deux substrats comprennent un semi-conducteur, à un traitement thermique de préparation avant collage, à une température comprise entre 900°C et 1200°C, dans une atmosphère gazeuse comprenant de l'hydrogène et/ou de l'argon, pendant une durée d'au moins 30 secondes,
• coller directement l'une contre l'autre, lesdites faces avant (11, 21) respectives des deux substrats à coller (1, 2).

## Description

La présente invention concerne le domaine de la fabrication d'un substrat hybride constitué de plusieurs couches, destiné à être utilisé dans des applications dans l'électronique, l'optique ou l'optoélectronique.

Plus précisément, l'invention a pour objet un procédé de collage "direct" de deux substrats, c'est-à-dire un collage moléculaire sans couche intermédiaire, telle qu'une couche d'adhésif Ce procédé peut être mis en oeuvre dans un procédé de fabrication d'un substrat hybride, tel que précité.

On connaît déjà, dans l'état de la technique, des procédés d'obtention d'un substrat hybride, fondés sur une étape de collage d'un substrat dit "donneur", qui comprend la couche à transférer, sur un substrat dit "receveur", sur lequel cette couche sera transférée. Généralement, une couche intermédiaire est intercalée entre les deux. Ce transfert est complété par une étape de retrait d'une partie, dite "reste" du substrat donneur, afin d'obtenir au final, ledit substrat hybride.

Celui-ci est composé successivement de la couche transférée, dont l'épaisseur varie de 0,01 µm à quelques microns, d'une couche intermédiaire, dont l'épaisseur est typiquement comprise entre 0,01 µm et 1 µm et du substrat receveur, d'une épaisseur de plusieurs centaines de microns.

Le retrait de la partie arrière du substrat donneur peut être réalisé, par exemple, par meulage et/ou attaque chimique de la face exposée du substrat donneur. Dans ce cas, on notera que la partie arrière du substrat donneur est entièrement consommée.

D'autres techniques consistent à former préalablement au collage, une zone de fragilisation à l'intérieur du substrat donneur, puis à retirer la partie arrière de ce substrat, par une fracture le long de cette zone de fragilisation.

Cette zone peut être obtenue par l'implantation d'espèces atomiques, telles que de l'hydrogène et/ou des gaz rares, cette technologie étant connue sous la marque Smart Cut™.

Cette zone fragilisée pourra également être obtenue par une zone poreuse, conformément au procédé connu sous la marque ELTRAN™.

On pourra se référer à l'article "Silicon-On-Insulator Technology; Materials to VLSI", 2ème Edition, par J.-P. Colinge, édité par Kluwer Academic Publishers, pages 50 et 51, pour une plus ample description de ces techniques.

Ces techniques de fabrication de substrats sont particulièrement adaptées et employées pour la formation de substrats, du type connu sous l'acronyme anglais "SeOI", qui signifie "semi conducteur sur isolant" et dont la forme la plus connue est le substrat "SOI", qui signifie "silicium sur isolant".

Lors de la fabrication de tels substrats, on forme une couche d'isolant sur la face du substrat donneur et/ou la face du substrat receveur, qui seront mis en contact intime lors de l'étape de collage.

Cette couche d'isolant peut être obtenue par le traitement de l'un des substrats, par exemple par oxydation thermique, ou encore, par le dépôt d'une couche d'oxyde. Dans le substrat final, cette couche d'isolant sera enterrée.

Dans toutes ces techniques de transfert de couches, la qualité du collage a un impact direct sur la qualité finale du substrat obtenu. En particulier, l'énergie de collage avec laquelle les deux substrats sont liés l'un à l'autre pendant l'étape ultérieure de retrait de la partie arrière du substrat donneur, est particulièrement importante.

On a pu observer que la planéité des substrats, la présence éventuelle de particules ou de contaminants à leur surface, la rugosité de ces surfaces, ou leur degré d'hydrophylie conditionnent directement l'énergie avec laquelle les deux substrats seront liés ensemble, après mise en contact intime.

On a constaté, dans l'état de la technique, qu'une couche intermédiaire, dénommée ci-après "couche de collage", suffisamment épaisse, c'est-à-dire dont l'épaisseur est supérieure à 50 nm, disposée entre deux substrats monocristallins, en facilitait le collage et limitait l'apparition de défauts, par exemple des cloques, à l'interface de mise en contact.

On pourra se reporter à ce sujet à l'ouvrage de "Q.-Y. Tong and U. Gôsele, Semiconductor Wafer Bonding Science and Technology, John Wiley & Sons, New York (1999).

Ainsi, dans le cas d'un substrat de type "SeOI", la couche d'isolant enterrée permet de faciliter le collage et de limiter les défauts de collage.

Or, il existe des situations où il serait préférable de limiter l'épaisseur de cette couche d'isolant enterrée à des valeurs inférieures à environ 50 nm (50 nanomètres), voire même de la supprimer complètement, afin de transférer directement la couche utile du substrat donneur, vers le substrat receveur.

Ceci est le cas par exemple, lorsque l'on veut optimiser la conduction thermique entre la couche transférée dans laquelle les composants microélectroniques seront formés, et le substrat receveur, et ceci, afin d'évacuer au maximum la chaleur générée par les composants lors de leur utilisation.

Le collage sans couche d'isolant enterrée permet également d'améliorer la conduction électrique entre la couche transférée et le substrat receveur et d'avoir au minimum, un contact électriquement conducteur.

Il pourrait également être souhaitable de combiner une couche transférée et un substrat receveur présentant des orientations cristallines respectives différentes, afin d'optimiser, par exemple, les performances des transistors qui pourraient être formés respectivement dans ces deux parties du substrat hybride.

A titre d'exemple, pour des composants de type CMOS (*"Complementary metal oxide semi-conductor*"), on pourrait envisager de réaliser le transistor NMOS sur la couche transférée, ou sur le substrat receveur, réalisé en silicium orienté (100) et le transistor PMOS, respectivement, sur le substrat receveur ou sur la couche transférée, réalisé en silicium orientée (110).

Les articles de K. L. Saenger et al., "Amorphization/templated recrystallization method for changing the orientation of single-crystal silicon : an alternative approach to hybrid orientation substrates", Appl. Phys. Lett., 87, 221911 (2005) et de C.-Y. Sung et al., "High performance CMOS bulk technology using direct silicon bond (DSB) mixed crystal orientation substrates", Tech. Dig. - Int. Electron Devices Meet., 2005, 236, exposent les différences de caractéristiques électriques du silicium selon son orientation cristalline.

Il pourrait également être utile de réaliser des substrats hybrides, comprenant un substrat receveur en silicium massif, recouvert d'une couche transférée en silicium, ou en germanium ou encore en silicium-germanium contraint élastiquement en tension ou en compression.

Des techniques de collage existent déjà. Il est toutefois difficile de les mettre en oeuvre industriellement, avec le niveau de qualité requis pour une application au transfert de couches, lorsqu'il s'agit de collage "direct", c'est-à-dire sans couche intermédiaire de collage additionnelle, ou de techniques utilisant une couche de collage d'une épaisseur limitée, inférieure à 50 nm (50 nanomètres) environ.

On pourra se reporter à ce sujet à l'article de S.L. Holl et al. ; "UV activation treatment for hydrophobic wafer bonding", Journal of the Electrochemical Society, 153 (7), G613 - G616 (2006) qui montre les difficultés à obtenir un collage sans défauts.

Ces techniques connues sont le collage hydrophile et le collage hydrophobe.

A titre d'exemple, le collage hydrophile du silicium sur du silicium consiste à réaliser un nettoyage hydrophile des substrats, avant leur mise en contact intime.

Ce nettoyage est typiquement réalisé par un procédé connu sous la dénomination "RCA", qui consiste à traiter les surfaces à coller, successivement avec :
- un premier bain d'une solution connue sous l'acronyme "SC1" (d'après la terminologie anglo-saxonne de "Standard Clean 1" qui signifie "solution de nettoyage standard 1"), et qui comprend un mélange d'hydroxyde d'ammonium (NH₄OH), de peroxyde d'hydrogène (H₂O₂) et d'eau déionisée, puis
- un second bain d'une solution connue sous l'acronyme "SC2" (d'après la terminologie anglo-saxonne de "Standard Clean 2" qui signifie "solution de nettoyage standard 2"), et qui comprend un mélange d'acide chlorhydrique (HCl), de peroxyde d'hydrogène (H₂O₂) et d'eau déionisée.

On peut également lire à ce sujet l'article de C. Maleville, O. Rayssac, H. Moriceau et al., Proc. 4th Internat. Symposium. on Semiconductor Wafer Bonding : PV 97-36 , ECS publications, p. 46, 1997.

Le collage hydrophobe est quant à lui habituellement réalisé par un nettoyage des surfaces dans un bain d'acide fluorhydrique (HF), avant leur mise en contact, ce nettoyage étant connu de l'homme du métier sous la dénomination *"HF last".* Un tel procédé de nettoyage est typiquement suivi d'étapes de rinçage et de séchage spécifiques, ce qui rend la procédure assez complexe. De plus les surfaces ainsi traitées sont très réactives aux contaminants métalliques et aux particules, ce qui impose de prendre des précautions particulières. L'industrialisation de cette technique n'est donc pas aisée.

D'autres procédés de collage hydrophobe existent, comme le nettoyage à la vapeur d'acide fluorhydrique (HF) ou le recuit sous vide ultra poussé (UHV pour "*ultra high vacuum").* On peut voir à ce sujet l'article de M. J. Kim and R. W. Carpenter, « Heterogeneous Silicon Integration by Ultra-High Vacuum Wafer Bonding », Journal of the Electrochemical Materials, Vol 32, No 8, 2003.

L'une des principales limitations des procédés précités est leur difficulté de mise en oeuvre, ce qui est le cas notamment pour le recuit sous vide ultra poussé, qui nécessite l'emploi d'un matériel coûteux.

De plus, les procédés de collage hydrophiles ou hydrophobes précités sont généralement suivis d'un recuit thermique entre 200°C et 1200°C, pendant quelques heures, par exemple pendant 2 heures. Or, après des recuits entre 200°C et 1100°C, on a pu observer des bulles, au niveau de l'interface de collage, par une technique de transmission infrarouge. Ce dégazage est probablement dû à la désorption des espèces présentes à l'interface de collage, que le collage soit hydrophile ou hydrophobe.

Par ailleurs, après des recuits entre 1100°C et 1200°C, ces bulles ne sont plus toujours observables par transmission par infrarouge. Toutefois, cette absence de bulles visibles ne signifie pas pour autant que le collage est parfait, c'est-à-dire qu'il présente une énergie de collage élevée. Sur ce sujet, on pourra se référer, par exemple, à l'article de R.D. Horning et R.R. Martin, « Wafer to wafer bond characterization by defect decoration etching », Second international Symposium on semi-conductor wafer bonding : Science Technology and applications. PV 93-29, p 199, 1993.

Il est même parfois possible d'observer des défauts après un recuit au-delà de 1100°C, en utilisant la technique de microscopie acoustique.

Il est possible de guérir ces défauts de collage ou de prévenir leur apparition par un traitement thermique, à une température supérieure ou égale à 1100°C. Toutefois, en fonction des applications ultérieures visées, il n'est pas toujours envisageable de mettre en oeuvre un traitement thermique à une température aussi élevée. Il peut même être parfois souhaitable de ne pas dépasser 200°C.

Des procédés permettant de limiter les défauts observés lors du collage direct ont été décrits dans la littérature. Il s'agit de la création de tranchées, ou de désorption des surfaces avant collage. Ces procédés ne sont toutefois pas complètement satisfaisants, comme mentionné dans l'article de R. H. Esser, K. D. Hobart and F. J. Kub, « Improved low temperature Si-Si hydrophilic wafer bonding », Journal of the electrochemical Society, 150 (3), G228-G231 (2003). En outre, de tels substrats munis de tranchées ne sont pas toujours utilisables dans certaines applications à la fabrication de composants électroniques.

L'invention vise à remédier aux inconvénients précités de l'état de la technique.

Elle a notamment pour objet d'offrir un procédé permettant de coller directement l'un contre l'autre, sans couche additionnelle de collage, deux substrats, dont l'un au moins comprend une couche de matériau semi-conducteur sur l'une de ses faces ou à proximité de celle-ci, et ce, avec une qualité satisfaisante et sans apparition de défauts de collage macroscopiques, tels que des bulles.

A cet effet, l'invention concerne un procédé de collage hydrophobe direct des faces, dites "avant", de deux substrats, aptes à être utilisés dans des applications dans le domaine de l'électronique, de l'optique ou de l'optoélectronique, l'un au moins de ces deux substrats, dit "substrat comprenant un semi-conducteur", comprenant une couche de matériau semi-conducteur qui s'étend sur sa face avant ou à proximité de celle-ci.

Conformément à l'invention, ce procédé comprend les étapes suivantes consistant à :
- soumettre au moins la face avant du substrat comprenant un semi-conducteur ou au moins l'une des faces avant des deux substrats si les deux substrats comprennent un semi-conducteur, à un traitement thermique, dit "traitement de préparation avant collage", à une température comprise entre 900°C et 1200°C, dans une atmosphère gazeuse comprenant de l'hydrogène et/ou de l'argon, pendant une durée d'au moins 30 secondes, afin de rendre hydrophobe(s) le ou les face(s) ainsi traitée(s),
- coller directement l'une contre l'autre, lesdites faces avant respectives des deux substrats à coller, ce collage direct étant effectué immédiatement après ledit traitement de préparation avant collage.

Ce procédé permet d'éliminer l'oxyde natif présent sur la surface traitée et permet également de passiver cette surface par les atomes d'hydrogène.

Contrairement à l'état de la technique, ce procédé peut-être utilisé avec de bons résultats, même si les substrats sont dépourvus d'une couche d'isolant ou s'ils sont pourvus d'une couche d'isolant mais d'une épaisseur inférieure à 50 nm (50 nanomètres) environ.

De plus, le traitement de préparation avant collage permet d'obtenir des niveaux de rugosité extrêmement faibles. On a pu mesurer une rugosité de 0,7 Å RMS sur un échantillon balayé de 2 microns sur 2 microns, alors que typiquement la surface d'un substrat de silicium présente une rugosité de l'ordre de 2 Å RMS et que les traitements habituels de préparation de surface avant collage (tels que les nettoyages de type SC1) ont tendance à rugosifier encore cette surface.

L'invention présente donc l'avantage complémentaire de mettre en contact des surfaces très peu rugueuses.

Selon d'autres caractéristiques avantageuses et non limitatives de l'invention, prises seules ou en combinaison :
- ledit traitement de préparation avant collage est effectué dans une atmosphère gazeuse contenant exclusivement de l'argon ou contenant exclusivement de l'hydrogène ;
- ledit traitement de préparation avant collage est effectué dans un four de recuit thermique rapide de type RTA ou dans un four traditionnel ou à l'intérieur d'une chambre de bâti d'épitaxie ;
- après ledit collage direct, on effectue un traitement thermique de consolidation du collage, à une température comprise entre 200°C et 1200°C, pendant environ au moins une heure, de préférence pendant moins de trois heures ;
- les deux substrats à coller comprennent un semi-conducteur et les faces avant de ces deux substrats subissent le traitement de préparation avant collage ;
- ledit matériau semi-conducteur est choisi parmi le silicium (100), le silicium (110) et le silicium (111) ;

L'invention concerne également un procédé de fabrication d'un substrat hybride, apte à être utilisé dans des applications dans le domaine de l'électronique, de l'optique ou de l'opto-électronique, qui comprend les étapes suivantes consistant à :
• sélectionner un substrat, dit "receveur", dont l'une des faces, est dite "avant",
• sélectionner un substrat, dit "donneur", qui comprend une couche de matériau à transférer, et une autre partie dite "reste", cette couche à transférer, s'étendant sur l'une des faces, dite "avant", du substrat donneur,
au moins l'un desdits substrats receveur et donneur comprenant une couche de matériau semi-conducteur qui s'étend sur sa face avant, ou à proximité de celle-ci,
• procéder au collage hydrophobe direct des deux faces avant respectives du substrat donneur et du substrat receveur, conformément au procédé précité,
• retirer le reste dudit substrat donneur, afin d'obtenir ledit substrat hybride qui comprend le substrat receveur et la couche transférée.

Selon d'autres caractéristiques avantageuses, prises seules ou en combinaison :
- au moins l'un des deux substrats donneur et receveur comprend une couche de matériau isolant sur ladite couche de matériau semi-conducteur et cette couche de matériau isolant s'étend sur la face avant dudit substrat ;
- ladite couche de matériau isolant présente une épaisseur inférieure ou égale à 50 nanomètres ;
- ladite couche de matériau isolant est une couche d'oxyde natif ;
- le retrait du reste du substrat donneur est effectué par amincissement mécanique et/ou chimique ;
- préalablement au collage direct, on forme à l'intérieur du substrat donneur, une zone de fragilisation et on effectue le retrait d'au moins une partie du reste du substrat donneur, le long de cette zone de fragilisation, par application de contraintes mécaniques, chimiques et/ou thermiques ;
- la zone de fragilisation est formée par implantation d'espèces atomiques, le substrat receveur comprend une couche de matériau semi-conducteur et seul ce substrat receveur est soumis au traitement de préparation avant collage ;
- la zone de fragilisation est une zone poreuse.

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins :
- les figures 1A à 1C représentent les différentes étapes d'un procédé de fabrication d'un substrat hybride, mettant en oeuvre le procédé de collage direct conforme à l'invention,
- les figures 2A à 2C, 3A à 3D et 4A à 4D illustrent respectivement trois variantes de réalisation du procédé précité.

L'invention concerne un procédé de collage direct, d'un substrat donneur, sur un substrat receveur.

Sur les figures, le substrat receveur porte la référence 1. Il présente une face 11, dite "avant", car destinée à venir au contact du substrat donneur 2, et une face opposée 12, dite "arrière".

De façon similaire, le substrat receveur 2 présente une face avant 21 et une face arrière 22.

Le substrat donneur 2 et le substrat receveur 1 peuvent être monocouche ou multicouches.

Au moins l'un des substrats donneur 2 et receveur 1 comprend une couche de matériau semi-conducteur.

En d'autres termes, l'un d'entre eux peut être réalisé dans un matériau autre que semi-conducteur, par exemple un matériau isolant, tel que le saphir ou un substrat oxydé.

La terminologie *"au moins l'un comprend une couche de matériau semi-conducteur"* signifie que l'un des deux substrats 1 ou 2 ou les deux est (sont) réalisé(s) en matériau semi-conducteur, soit en totalité lorsqu'il(s) est (sont) monocouche, soit au moins en partie, lorsqu'il(s) est (sont) multicouches.

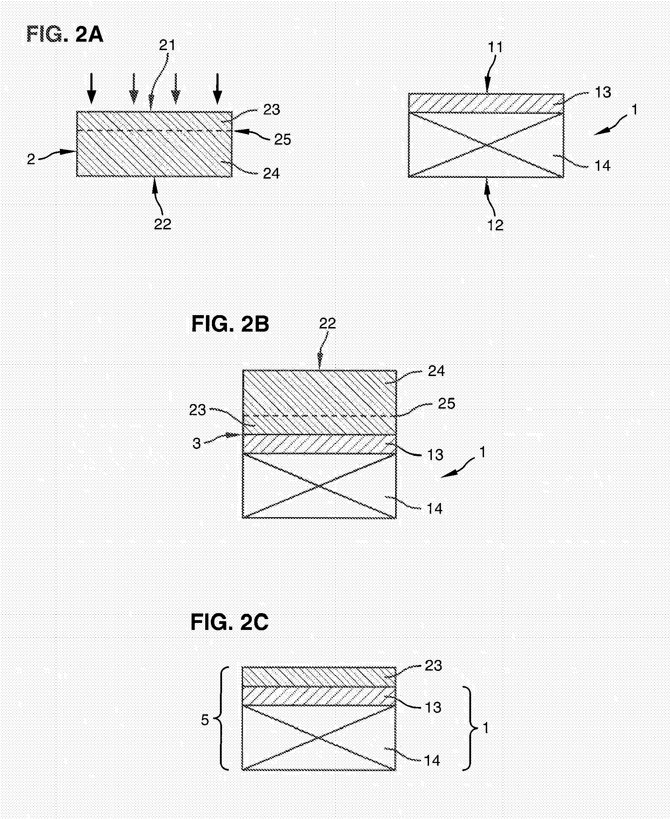

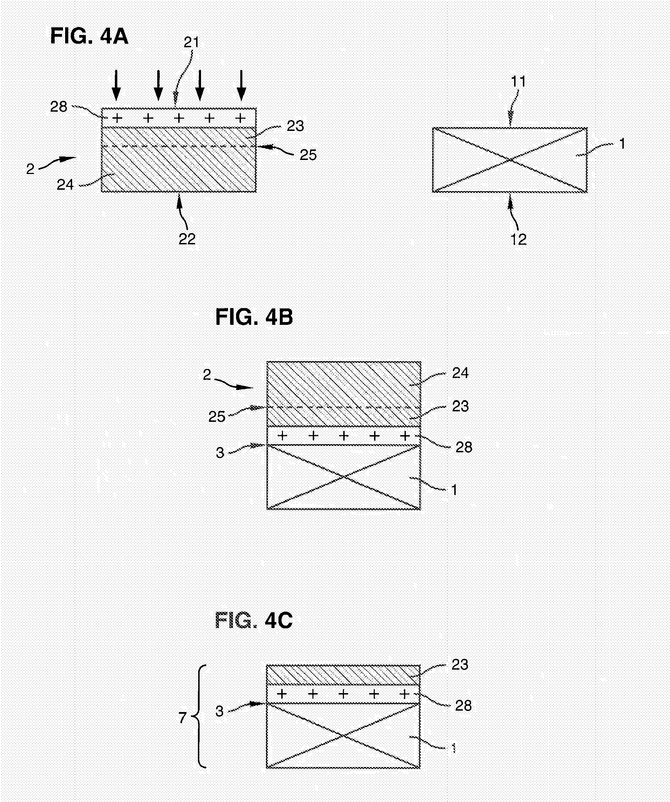

Dans ce dernier cas, la couche de matériau semi-conducteur s'étend le long de la face avant du substrat (voir par exemple la figure 2A) ou à proximité de celle-ci (voir par exemple la figure 4A). Le terme *"à proximité"* signifie que la couche de matériau semi-conducteur peut être recouverte d'une mince couche d'isolant, par exemple d'oxyde, inférieure à environ 10 nm, voire même d'une très fine couche d'isolant dont l'épaisseur est de l'ordre de quelques Angströms, par exemple une couche d'oxyde natif (1 nanomètre = 10 Angströms).

De façon similaire, le substrat monocouche en matériau semi-conducteur peut également être recouvert d'une couche d'isolant telle que décrite au paragraphe précédent.

Les matériaux semi conducteurs sont ceux généralement utilisés fréquemment dans le domaine de la micro électronique, à savoir par exemple le silicium (100), le silicium (110), le silicium (111), la référence numérique désignant le type cristallographique.

L'invention consiste à soumettre au moins l'une des faces à coller, c'est-à-dire au moins l'une des faces avant 11 et/ou 21, à un traitement thermique, à une température comprise entre 900 et 1200°C, dans une atmosphère gazeuse comprenant de l'hydrogène et/ou de l'argon, mais pas d'oxygène.

Lorsque les deux substrats comprennent un matériau semi-conducteur, on effectuera ce traitement de préférence sur chacune de leur face avant.

L'atmosphère gazeuse peut donc comporter au choix : exclusivement de l'hydrogène, ou exclusivement de l'argon, ou un mélange des deux, voire même l'un ou l'autre ou les deux associés à un autre gaz, à l'exclusion de l'oxygène.

La durée du traitement est d'au moins 30 secondes et de préférence n'excède pas quelques minutes.

L'hydrogène et/ou l'argon a pour effet d'éliminer l'oxyde natif éventuellement présent sur la ou les face(s) avant traitée(s) et de passiver ces surfaces par des atomes d'hydrogène. Il permet également d'obtenir des rugosités de surface très faibles.

Ce traitement de préparation avant collage a également pour effet de rendre les surfaces collées hydrophobes. Cet effet a été mis en évidence par la mesure de l'angle de contact d'une goutte d'eau qui conduit à une valeur de 80°. Cette valeur est largement supérieure à la valeur que l'on obtient après un traitement du type *"HF last",* qui est typiquement de 70°, voir l'article de Y. Bäcklünd, Karin Hermasson, L. Smith, « Bond-strength measurements related to silicon surface hydrophilicity », J. Electrochem. Soc., Vol. 1398, No8, 1992.

L'avantage du procédé conforme à l'invention est qu'aucune espèce n'est adsorbée sur la surface. Comme l'atome d'hydrogène est très petit, lorsqu'il va désorber pour permettre la création de liaisons covalentes entre les faces avant 11 et 21 en vis-à-vis, il ne va pas rester piégé à l'interface, va diffuser dans le matériau et ne génèrera pas de défaut de dégazage.

De plus, le procédé conforme à l'invention étant un traitement à sec, contrairement par exemple au traitement *"HF last*" précité, il est plus simple de le mettre en oeuvre car il ne nécessite pas de séchage.

Le procédé conforme à l'invention peut être mis en oeuvre dans une chambre permettant des recuits à haute température, sous une atmosphère contrôlée, par exemple un four de type "RTA" (pour *"Rapid Thermal Annealing"*) monoplaque ou encore une chambre de bâti d'épitaxie.

L'utilisation d'un four traditionnel, dans lequel les substrats sont traités par lots, peut également être envisagée.

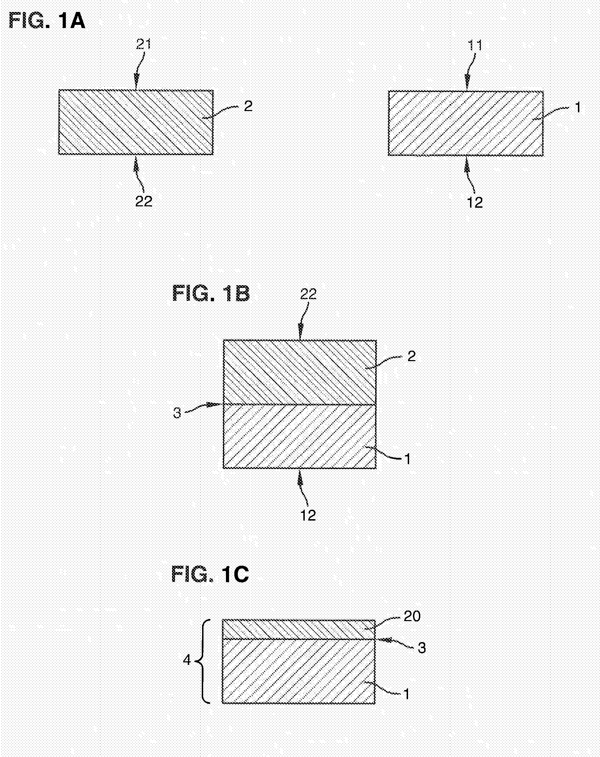

Après le traitement de surface précité, le collage doit se faire très rapidement, afin de limiter au maximum les risques de contamination par l'atmosphère ambiant, des faces avant traitées. Cette étape de collage est représentée sur les figures 1B, 2B, 3B et 4B.

L'interface de collage porte la référence 3.

Il a également été remarqué que les surfaces préparées par la méthode suivant l'invention étaient beaucoup moins réactives que des surfaces préparées par le procédé précité *« HF last* », ce qui permet de limiter la contamination en particules de ces surfaces. L'industrialisation en est rendue plus simple.

De façon avantageuse, il est également possible après le collage, de procéder à un traitement thermique de pré-consolidation ou de consolidation, à une température comprise 200°C et 1200°C, de préférence au voisinage d'au moins 1100°C si l'on souhaite consolider entièrement l'interface.

De préférence, ce traitement dure environ au moins une heure et de préférence, moins de trois heures, de façon à renforcer le collage. Cette étape de pré-consolidation ou consolidation se déroule sans formation de bulles, ce qui assure une bonne énergie de collage en tout endroit de la plaque.

Ce procédé de collage direct peut être mis en oeuvre dans un procédé de fabrication d'un substrat hybride.

Ce procédé de fabrication d'un substrat hybride comprend les étapes suivantes consistant à :
- sélectionner un substrat donneur 2 et un substrat receveur 1 du type précité,
- effectuer les étapes de traitement de surface et de collage conformes au procédé de collage direct qui vient d'être décrit, et
- retirer une partie du substrat donneur, afin d'obtenir un substrat hybride, qui comprend le substrat receveur 1, sur lequel est collée la couche transférée, issue du substrat donneur.

En se reportant aux figures 1A à 1C, on peut voir un exemple de réalisation d'un substrat hybride 4, à partir de substrats donneur 2 et receveur 1, tous les deux monocouche.

Après le traitement de surface conforme à l'invention et le collage, le retrait d'une partie dénommée "reste", du substrat donneur 2, est effectué par un amincissement mécanique du type ponçage et polissage, jusqu'à obtenir la couche transférée 20.

Les figures 2A à 2C illustrent une variante de réalisation, dans laquelle le substrat donneur 2 comporte une zone de fragilisation 25.

Dans cet exemple, cette zone de fragilisation 25 est obtenue par l'implantation d'espèces atomiques, par exemple d'ions hydrogène, conformément au procédé connu sous la dénomination SMART CUT™. La zone de fragilisation 25 délimite une couche à transférer 23, du reste 24 du substrat donneur 2.

Dans ce cas, on notera que le substrat donneur ne peut subir ensuite le traitement de préparation avant collage précédemment décrit. En effet, le traitement thermique selon l'invention risquerait d'introduire la formation de bulles au niveau de la face avant 21. Seul le substrat receveur 1 sera soumis à un tel traitement.

Ce substrat 1 comprend une couche de matériau semi-conducteur 13, par exemple en silicium, et pourra comporter en surface une fine couche d'oxyde natif.

On pourra éventuellement traiter le substrat donneur 2, suivant la méthode *"HF last"* précitée ou une autre technique permettant d'obtenir une surface hydrophobe. Ce substrat donneur peut comporter une couche non semi conductrice en face avant.

Selon une variante de réalisation, non représentée sur les figures, la zone de fragilisation 25 pourrait également être une couche poreuse, obtenue par exemple, par le procédé connu sous la marque ELTRAN.

Après le traitement de surface et le collage direct des deux substrats 1 et 2, le reste 24 du substrat donneur 2 est retiré, par application de contraintes de type mécanique, chimique et/ou thermique, conformément aux techniques couramment employées dans la mise en oeuvre du procédé Smart Cut ™.

On obtient le substrat hybride 5 représenté sur la figure 2C, qui comprend les couches 13 et 23 en matériau semi-conducteur et la couche 14 du substrat receveur 1.

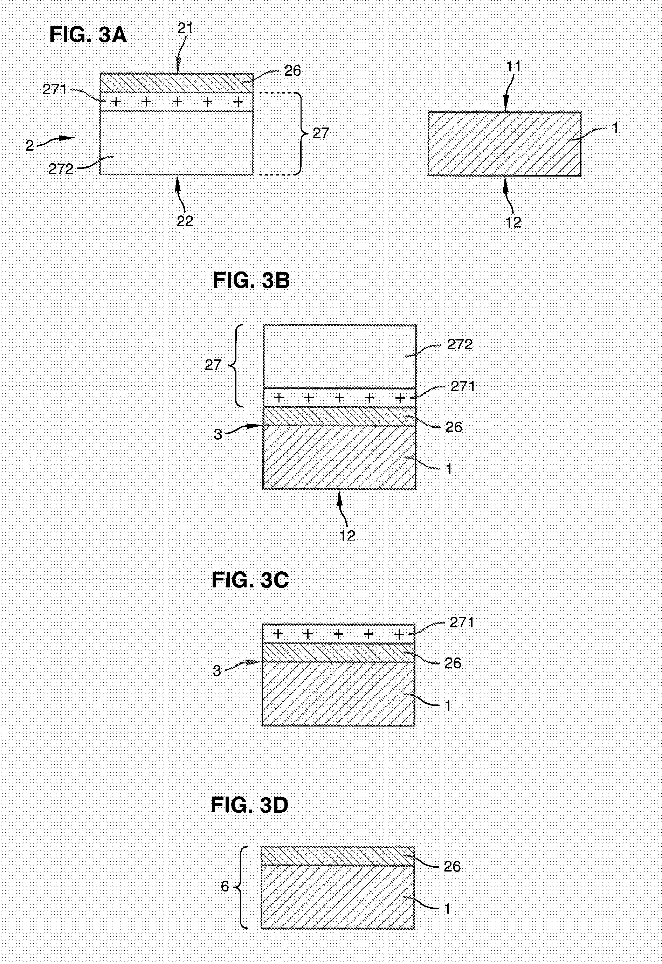

Les figures 3A à 3C illustrent un autre exemple de réalisation d'un substrat hybride conforme à l'invention, dans lequel le substrat donneur 2 est un substrat du type semi-conducteur sur isolant. Le substrat receveur 1 est identique à celui décrit en figure 1A.

Le substrat donneur 2 comprend deux couches de matériau semi-conducteur 26 et 272, et une couche d'isolant 271.

Après l'étape de collage illustrée sur la figure 3B, le retrait du reste 27 est effectué en deux étapes.

Une première étape représentée sur la figure 3C consiste en un retrait mécanique de la couche 272, par ponçage puis polissage.

La seconde étape consiste à retirer la couche d'isolant 271, par exemple par attaque chimique.

Le substrat final obtenu, qui comporte le substrat receveur 1, sur lequel est collée la couche transférée 26, porte la référence numérique 6.

Les différentes techniques de retrait du reste de substrat donneur 2 qui viennent d'être décrites peuvent également être utilisées en combinaison, en fonction de la nature du substrat donneur 2.

Enfin, une quatrième variante de réalisation de l'invention va maintenant être décrite en liaison avec les figures 4A à 4C.

Le substrat receveur 1 est monocouche, il n'est pas semi-conducteur.

Le substrat donneur 2 est similaire à celui de la figure 2A, et est recouvert d'une couche d'isolant 28.

Après le traitement de préparation avant collage conforme à l'invention, après les étapes de collage (et éventuellement de consolidation) conformes à ce qui a été décrit précédemment et réprésentées sur la figure 4B, et après le retrait du reste 24, on obtient le substrat hybride 7.

Le substrat hybride 7 comprend le receveur 1 et les couches transférées isolante 28 et semi-conductrice 23.

Cinq exemples de réalisation d'un substrat hybride silicium-silicium vont maintenant être décrits.

### Exemple 1

Le substrat donneur 2 et le substrat receveur 1 sont des substrats en silicium d'orientation cristalline (100), de diamètre 300 mm.

Les deux substrats 1 et 2 sont soumis à un traitement thermique, à une température de 1060°C, pendant une durée de 3 minutes, dans une atmosphère contenant 100 % d'hydrogène.

Le traitement a été effectué dans un bâti d'épitaxie. Au préalable, les substrats avaient été nettoyés dans des bains d'ozone + solution SC1, puis rincés à l'eau déionisée.

Le nombre de particules additionnelles a été mesuré par un dispositif d'analyse de surface par laser, commercialisé sous la marque Surfscan SP1, par la société KLA-Tencor. Les mesures ont été effectuées avant le traitement de surface, puis avant le collage. On a pu constater que le traitement conforme à l'invention avait conduit à ajouter moins de 50 particules de taille 0,13 micron et plus.

On a ensuite procédé au collage direct des faces avant respectives du substrat donneur et du substrat receveur.

L'empilement obtenu a subi un traitement thermique de consolidation à une température voisine de 1100°C pendant 2 heures.

La qualité du collage a été mesurée par microscopie acoustique : aucun défaut de collage n'a été détecté.

### Exemple comparatif :

Des plaques (substrats) de silicium ont été préparées par un nettoyage similaire à celui effectué dans l'exemple 1, puis soumises à un traitement *"HF last".*

Avant collage, le niveau de particules additionnelles à été compté à plus de 800, de dimensions 0.13 micron et plus.

Après collage et recuit de consolidation à 1100°C pendant 2 heures, on a pu observer par microscopie acoustique, des défauts de collage.

Le procédé conforme à l'invention est donc plus efficace, voir exemple 1.

### Exemple 2 : Analyse du collage hydrophobe après différents types de recuits thermiques de pré-consolidation ou consolidation.

On a procédé comme dans l'exemple 1, mais ici on a fait suivre le collage par différents recuits thermiques mentionnés ci-après :
a) Température de recuit : 200°C ; durée : 2 heures.
b) Température/durée de recuit : 350°C pendant 2 heures, suivi d'une montée à 500°C avec une rampe de 5°C/min, suivi d'un plateau à 500°C pendant une heure.
c) Température/durée de recuit : même recuit que dans b), mais avec montée à un plateau de 700°C.
d) Température/durée de recuit : même recuit que dans b), mais avec montée à un plateau de 900°C.

On a observé au microscope acoustique les substrats une fois collés, respectivement avant le traitement thermique de recuit et après.

Aucun ne présentait de bulles.

Par ailleurs, des substrats ont été préparés par recuit dans un four de type RTA à 1100°C, pendant 60 secondes, dans une atmosphère contenant 20% d'hydrogène et 80% d'argon, puis collés et ont subi les mêmes recuits de consolidation.

On a observé les mêmes bons résultats, c'est-à-dire l'absence de défauts de collage, tels que des bulles.

### Exemple 3.

Cet exemple correspond à une variante de l'exemple précité, dans laquelle le substrat donneur 2 est un substrat de type SOI, dont la couche superficielle en silicium constitue la couche à transférer. La couche de silicium et celle d'oxyde de silicium, sont retirées respectivement par polissage et TMAH et par gravure chimique à l'acide fluoridrique (HF). On obtient un substrat receveur 1 recouvert d'une couche de silicium transférée.

Les essais ont été répétés en les faisant suivre des différents traitements de pré-consolidation ou consolidation mentionnés dans l'exemple 2.

Les substrats hybrides obtenus ne présentaient pas de bulles.

### Exemple 4.

Cet exemple constitue une variante de l'exemple 1, dans laquelle le substrat donneur subit une implantation d'espèces atomiques, afin d'y former une zone de fragilisation.

Dans ce cadre, ce substrat donneur pourra être oxydé avant l'étape d'implantation. La couche d'oxyde peut être constituée d'un oxyde natif de quelques nanomètres d'épaisseur ou avoir été formée volontairement et atteindre une épaisseur voisine de 50 nm.

L'implantation consiste à implanter des ions hydrogène à une dose de 5.10¹⁶H⁺/cm², avec une énergie de 60 keV, de manière à localiser le pic de concentration en hydrogène au niveau de la zone de fragilisation, constituée par les défauts enterrés.

Comme expliqué précédemment, le substrat donneur ne peut subir le traitement conforme à l'invention. Il peut être soumis à un traitement habituel de surface, hydrophile ou hydrophobe, comme par exemple le traitement "RCA" décrit précédemment.

Le substrat receveur en silicium a subi le traitement conforme à l'invention.

Les deux substrats donneur et receveur ont ensuite été mis en contact par leurs faces avant respectives, puis ont subi un traitement de pré-consolidation à 200°C.

Le détachement du reste du substrat donneur est effectué par l'application de contraintes thermiques, à savoir un traitement à une température de 400 à 600°C environ, pendant 2 à 8 heures ou par application de contraintes mécaniques.

Le substrat final subit ensuite avantageusement une étape de finition, car sa surface libre a légèrement été endommagée lors du détachement le long de la zone de fragilisation. Cette étape de finition peut être effectuée par un traitement thermique de lissage, par oxydation sacrificielle et/ou par polissage.

Aucune bulle n'a été observée au niveau de l'interface de collage.

Afin d'améliorer la tenue mécanique du collage, on pourra prévoir une étape complémentaire d'activation plasma d'une ou des faces à mettre en contact.

## Revendications

1. Procédé de collage hydrophobe direct des faces (11, 21), dites "avant" de deux substrats (1, 2), destinés à être utilisés dans des applications dans le domaine de l'électronique, de l'optique ou de l'opto-électronique, l'un au moins de ces deux substrats (1, 2), dit "substrat comprenant un semi-conducteur" comprenant une couche de matériau semi-conducteur (1, 13, 2, 20, 23, 26) qui s'étend sur sa face avant (11, 21), ou à proximité de celle-ci, ce procédé étant **caractérisé en ce qu'**il comprend les étapes suivantes consistant à :
- soumettre au moins la face avant (11, 21) du substrat comprenant un semi-conducteur ou au moins l'une des faces avant (11, 21) des deux substrats si les deux substrats comprennent un semi-conducteur, à un traitement thermique, dit "traitement de préparation avant collage", à une température comprise entre 900°C et 1200°C, dans une atmosphère gazeuse comprenant de l'hydrogène et/ou de l'argon, pendant une durée d'au moins 30 secondes, afin de rendre hydrophobe la ou les face(s) ainsi traitée(s),
- coller directement l'une contre l'autre, lesdites faces avant (11, 21) respectives des deux substrats à coller (1, 2), ce collage direct étant effectué immédiatement après ledit traitement de préparation avant collage.

2. Procédé selon la revendication 1, **caractérisé en ce que** ledit traitement de préparation avant collage est effectué dans une atmosphère gazeuse contenant exclusivement de l'argon.

3. Procédé selon la revendication 1, **caractérisé en ce que** ledit traitement de préparation avant collage est effectué dans une atmosphère gazeuse contenant exclusivement de l'hydrogène.

4. Procédé selon l'une des revendications précédentes, **caractérisé en ce que** ledit traitement de préparation avant collage est effectué dans un four de recuit thermique rapide de type RTA.

5. Procédé selon l'une des revendications 1 à 3, **caractérisé en ce que** ledit traitement de préparation avant collage est effectué dans un four traditionnel.

6. Procédé selon l'une des revendications 1 à 3, **caractérisé en ce que** ledit traitement de préparation avant collage est effectué à l'intérieur d'une chambre de bâti d'épitaxie.

7. Procédé selon l'une des revendications précédentes, **caractérisé en ce qu'**après ledit collage direct, on effectue un traitement thermique de consolidation du collage, à une température comprise entre 200°C et 1200°C, pendant environ au moins une heure.

8. Procédé selon l'une des revendications précédentes, **caractérisé en ce qu'**après ledit collage direct, on effectue un traitement thermique de consolidation du collage, à une température comprise entre 200°C et 1200°C, pendant moins de trois heures.

9. Procédé selon l'une des revendications précédentes, **caractérisé en ce que** les deux substrats à coller (1, 2) comprennent un semi-conducteur et **en ce que** les faces avant (11, 21) de ces deux substrats subissent le traitement de préparation avant collage.

10. Procédé selon l'une des revendications précédentes, **caractérisé en ce que** ledit matériau semi-conducteur est choisi parmi le silicium (100), le silicium (110) et le silicium (111).

11. Procédé de fabrication d'un substrat hybride (4, 5, 6, 7), apte à être utilisé dans des applications dans le domaine de l'électronique, de l'optique ou de l'opto-électronique, **caractérisé en ce qu'**il comprend les étapes suivantes consistant à :
•sélectionner un substrat (1), dit "receveur", dont l'une des faces (11), est dite "avant",
• sélectionner un substrat (2), dit "donneur", qui comprend une couche de matériau à transférer (20, 23, 26, 28), et une autre partie (24, 27) dite "reste", cette couche à transférer (20, 23, 26), s'étendant sur l'une des faces (21), dite "avant", du substrat donneur (2),
au moins l'un desdits substrats receveur (1) et donneur (2) comprenant une couche de matériau semi-conducteur (1, 13, 2, 20, 23, 26) qui s'étend sur sa face avant (11, 21), ou à proximité de celle-ci,
• procéder au collage hydrophobe direct des deux faces avant (21, 11) respectives du substrat donneur (2) et du substrat receveur (1), conformément au procédé selon l'une des revendications précédentes,
• retirer le reste (24, 27) dudit substrat donneur (2), afin d'obtenir ledit substrat hybride (4, 5, 6, 7) qui comprend le substrat receveur (1) et la couche transférée (20, 23, 26, 28).

12. Procédé selon la revendication 11, **caractérisé en ce qu'**au moins l'un des deux substrats donneur (2) et receveur (1) comprend une couche de matériau isolant (28) sur ladite couche de matériau semi-conducteur (1, 13, 2, 20, 23, 26) et **en ce que** cette couche de matériau isolant (28) s'étend sur la face avant (21, 11) dudit substrat.

13. Procédé selon la revendication 12, **caractérisé en ce que** ladite couche de matériau isolant (28) présente une épaisseur inférieure ou égale à 50 nanomètres.

14. Procédé selon la revendication 12 ou 13, **caractérisé en ce que** ladite couche de matériau isolant (28) est une couche d'oxyde natif.

15. Procédé selon l'une des revendications 11 à 14, **caractérisé en ce que** le retrait du reste (24, 27) du substrat donneur (2) est effectué par amincissement mécanique et/ou chimique.

16. Procédé selon l'une des revendications 11 à 15, **caractérisé en ce que** préalablement au collage direct, on forme à l'intérieur du substrat donneur (2), une zone de fragilisation (25) et **en ce qu'**on effectue le retrait d'au moins une partie du reste (24, 27) du substrat donneur (2), le long de cette zone de fragilisation (25), par application de contraintes mécaniques, chimiques et/ou thermiques.

17. Procédé selon la revendication 16, **caractérisé en ce que** la zone de fragilisation (25) est formée par implantation d'espèces atomiques, **en ce que** le substrat receveur (1) comprend une couche de matériau semi-conducteur (1, 13) et **en ce que** seul ce substrat receveur (1) est soumis au traitement de préparation avant collage.

18. Procédé selon la revendication 16, **caractérisé en ce que** la zone de fragilisation (25) est une zone poreuse.
